# EUROPEAN PATENT SPECIFICATION

(11) **EP 2 973 706 B1**
(45) Date of publication and mention of the grant of the patent: **30.12.2020**
(21) Application number: 14712553.8
(22) Date of filing: 11.03.2014
(51) Int. Cl.: H01L 27/11, H01L 27/06, G11C 5/02, G11C 11/412

(54) **THREE-DIMENSIONAL (3D) MEMORY CELL WITH READ/WRITE PORTS AND ACCESS LOGIC ON DIFFERENT TIERS OF THE INTEGRATED CIRCUIT**
DREIDIMENSIONALE SPEICHERZELLE (3D) MIT SCHREIB-/LESEPORTS AUF UNTERSCHIEDLICHEN EBENEN DES INTEGRIERTEN SCHALTKREISES
CELLULES DE MÉMOIRE TRIDIMENSIONNELLES (3D) AVEC PORTS DE LECTURE ET PORTS DE ÉCRITURE SUR DIFFERENTES NIVEAUX DE CIRCUIT INTÉGRÉ

(30) Priority: 15.03.2013 US 201361800220 P; 11.07.2013 US 201313939274
(43) Date of publication of application: 20.01.2016
(73) Proprietor: Qualcomm Incorporated, San Diego, CA 92121 (US)
(72) Inventor: XIE, Jing, San Diego, California 92121 (US); DU, Yang, San Diego, California 92121 (US)
(74) Representative: Carstens, Dirk Wilhelm
(86) International application number: PCT/US2014/022929
(87) International publication number: WO 2014/150317

(56) References cited:
- US-A1- 2004 084 676
- US-A1- 2004 113 207
- US-A1- 2005 280 061
- US-A1- 2008 283 995
- US-A1- 2010 109 164
- US-A1- 2011 222 332

## Description

### BACKGROUND

### I. Field of the Disclosure

The technology of the disclosure relates generally to three-dimensional (3D) integrated circuits (IC) (3DICs) and their use for processor cores, including central processing unit (CPU) cores and other digital processor cores.

### II. Background

In processor-based architectures, memory structures are used for data storage. An example of a memory structure is a register. A register is a small amount of storage available as part of a processing unit, such as a central processing unit (CPU) or other digital processor. Registers are used for temporary storage of data as part of instruction executions by the arithmetic and logic unit (ALU). Registers have faster access times than main memory. Data from memory such as a cache memory is loaded into registers by operation of instructions to be used for performing arithmetic operations and manipulation. The manipulated data stored in a register is often stored back in main memory, either by the same instruction or a subsequent instruction.

A register file is an array of process registers in a processing unit. The register file plays a key role in processor operations, because it is usually the busiest storage unit in a processor-based system. Modern integrated circuit-based register files are usually implemented by way of fast static random access memories (SRAMs) with multiple ports. SRAM-based register files have dedicated read and write ports to provide for faster read and write access, whereas ordinary multi-ported SRAMs share read and write accesses through the same ports.

Register files have several characteristics that can affect their performance. For example, providing larger register files requires a large footprint area in an integrated circuit (IC). Larger footprint areas can increase register file access latency. Larger footprint areas can also increase peripheral logic areas and produce retiming arcs for other components placed around the register files. Multiple supply voltage rails may be used to provide sufficient voltage to avoid inadvertent flips in the stored bit due to insufficient static noise margins (SNMs) and read/write (R/W) noise margins (RWNMs). If multiple power supply rails are provided inside the register file to be able to separately supply and lower supply voltage for SRAM read access ports, additional area in the IC will be required for the register file. Many of these issues are exacerbated in multi-core processing units such as are used in many conventional computers.
The document US 2004/084676 A1 discloses a semiconductor memory device comprising a plurality of word lines, a plurality of bit lines, and a plurality of static memory cells each having first, second, third, fourth, fifth, and sixth transistors. While each of channels of the first, second, third, and fourth transistors are formed vertical against a substrate of the semiconductor memory device, each of semiconductor regions forming a source or a drain of the fifth and sixth transistors forms a PN junction against the substrate.

US 2008/283995 A1 discloses a multi-ported CAM cell in which the negative effects of increased travel distance have been substantially reduced by utilizing three-dimensional integration in which multiple active circuit layers are vertically stack and vertically aligned interconnects are employed to connect a device from one of the stacked layers to another device in another stack layer. By vertically stacking multiple active circuit layers with vertically aligned interconnects, each compare port of the multi-port CAM can be implemented on a separate layer above or below the primary data storage cell. This allows the multi-port CAM structure to be implemented within the same area footprint as a standard Random Access Memory (RAM) cell, minimizing data access and match compare delays.

US 2010/0109164 A1 discloses vias to connect stacked memory circuits.

### SUMMARY OF THE DISCLOSURE

According to the invention, a memory block according to claim 1 and a method according to claim 6 are provided. Embodiments of the invention are claimed in the dependent claims.

Embodiments disclosed herein include three-dimensional (3D) memory cell separation among 3D integrated circuit (IC) (3DIC) tiers. Related 3DICs, 3DIC processor cores, and methods are also disclosed. In embodiments disclosed herein, memory read access ports of a memory block are separated from a memory cell in different tiers of a 3DIC. 3DICs achieve higher device packing density, lower interconnect delays, and lower costs. In this manner, different supply voltages can be provided for the read access ports and the memory cell to be able to lower supply voltage for the read access ports. Improved static noise margins (SNMs) and read/write (R/W) noise margins (RWNMs) in the memory cell may be provided as a result. Providing multiple power supply rails inside a non-separated memory block that increases area can also be avoided.

In this regard in one embodiment, a 3D memory block is disclosed. The 3D memory block comprises a memory cell disposed in a first tier of a 3DIC. The 3D memory block also comprises at least one read access port disposed in a second tier of the 3DIC, the at least one read access port is configured to provide read access to the memory cell. The 3D memory block also comprises at least one monolithic intertier via (MIV) coupling the at least one read access port to the memory cell.

In another embodiment, a 3D memory block is disclosed. The 3D memory block comprises a memory cell disposed in a first tier of a 3DIC. The 3D memory block also comprises at least one means for reading disposed in a second tier of the 3DIC, the at least one means for reading configured to provide read access to the memory cell. The 3D memory block also comprises at least one MIV coupling the at least one means for reading to the memory cell.

In another embodiment, a method of forming a 3D memory block is disclosed. The method includes forming a first tier of a 3DIC. The method also includes forming a memory cell within the first tier of the 3DIC. The method also includes forming a second tier of the 3DIC. The method also includes forming at least one read access port within a second tier of the 3DIC, the at least one read access port is configured to provide read access to the memory cell. The method also includes coupling the at least one read access port to the memory cell with at least one MIV.

### BRIEF DESCRIPTION OF THE FIGURES

Figure 1A is a block diagram of an exemplary conventional register file;
Figure 1B is a block diagram of an exemplary conventional register file with multiple read and write ports;
Figure 2 is a simplified schematic of an exemplary conventional four bit register;
Figure 3A is a simplified block diagram of an exemplary integrated circuit (IC) having a single core;
Figure 3B is a simplified block diagram of an exemplary IC having multiple cores;
Figure 4 is a simplified block diagram of an exemplary monolithic three dimensional (3D) IC (3DIC) with a register spread across multiple tiers of the 3DIC;
Figure 5 is a cross-sectional view of an exemplary 3DIC having a register spread across multiple tiers of the 3DIC; and
Figure 6 is a block diagram of an exemplary processor-based system that can include the register of Figure 4 or 5.

### DETAILED DESCRIPTION

With reference now to the drawing figures, several exemplary embodiments of the present disclosure are described. The word "exemplary" is used herein to mean "serving as an example, instance, or illustration." Any embodiment described herein as "exemplary" is not necessarily to be construed as preferred or advantageous over other embodiments.

Embodiments disclosed in the detailed description include three-dimensional (3D) memory cell separation among 3D integrated circuit (IC) (3DIC) tiers. Related 3DICs, 3DIC processor cores, and methods are also disclosed. In embodiments disclosed herein, memory read access ports of a memory block are separated from a memory cell in different tiers of a 3DIC. 3DICs achieve higher device packing density, lower interconnect delays, and lower costs. In this manner, different supply voltages can be provided for the read access ports and the memory cell to be able to lower supply voltage for the read access ports. Static noise margins (SNMs) and read/write (R/W) noise margins (RWNMs) in the memory cell may be provided as a result. Providing multiple power supply rails inside a non-separated memory block that increases area can also be avoided.

Monolithic 3DIC offers additional degrees of freedom to reorganize logic systems for high density and low power designs. A register file, which is arguably the busiest storage unit, plays a crucial role connecting the logic operating units. The present disclosure provides a register file core cell design with either bit or bit bar (bitb) signal connected to transistors in at least two tiers of a 3DIC. In this design, the cell voltage, read access power supplies, and write access power supplies are decoupled to improve R/W margins and power consumption. The footprint of the register file can also be significantly reduced. While the present disclosure is well suited for use with register files, the present disclosure is also applicable to other memory devices such as cache memory or random access memory (RAM) and particularly to static RAM (SRAM). Collectively such memory types are referred to herein as a "memory block."

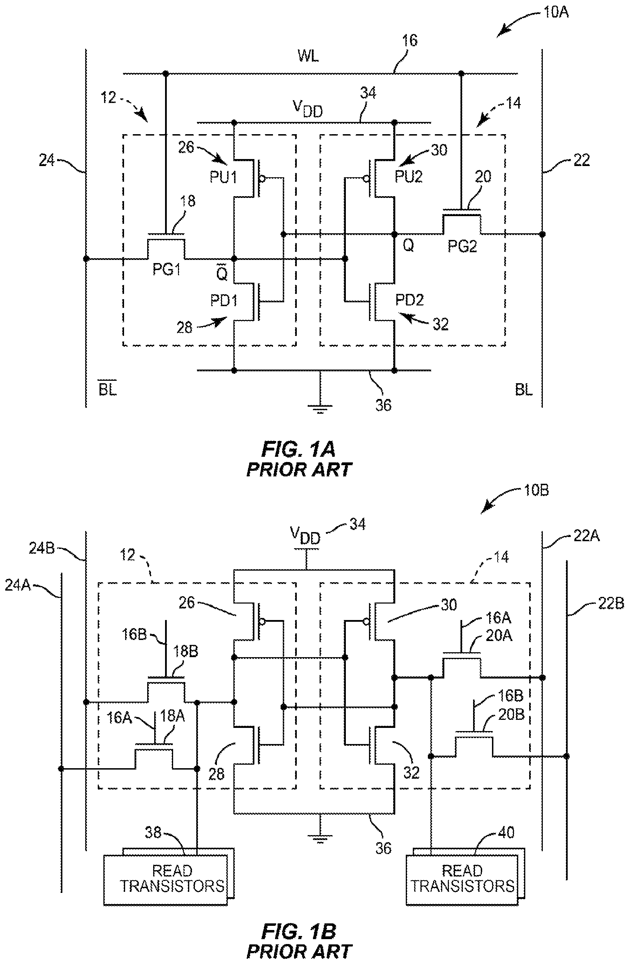

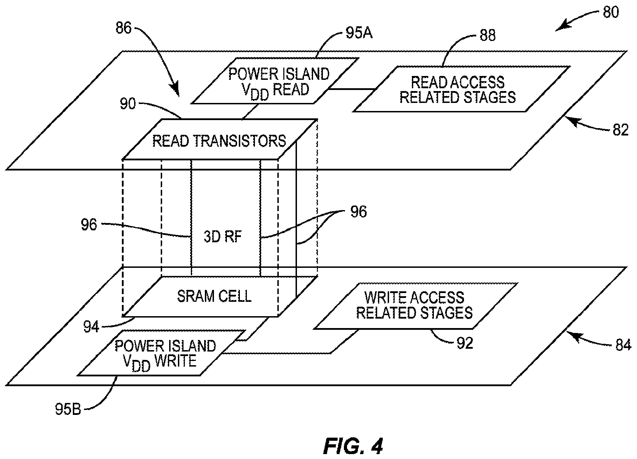

Before addressing the particulars of the multi-tier register in a 3DIC a brief overview of the elements of a register and how a register fits within a processing system is provided with reference to Figures 1A-3B. The discussion of the multi-tier register of the present disclosure begins with reference to Figure 4.

In this regard, Figure 1A is a circuit diagram of an exemplary SRAM bit cell 10A having a first inverter 12 and a second inverter 14. A word line (WL) 16 couples to both inverters 12, 14. In particular, the WL 16 couples to the first inverter 12 through a gate of a first pass gate (PG) transistor 18 (PG1) and couples to the second inverter 14 through a gate of a second PG transistor 20 (PG2). A bit line 22 couples to a drain of the second PG transistor 20. A bit line bar 24 couples to a source of the first PG transistor 18.

With continued reference to Figure 1A, the first inverter 12 includes a first pull up (PU) transistor 26 (PU1) and a first pull down (PD) transistor 28 (PD1). The second inverter 14 includes a second PU transistor 30 (PU2) and a second PD transistor 32 (PD2). A voltage source V_{DD} 34 couples to the first and second PU transistors 26, 30. The PD transistors 28, 32 are coupled to ground 36.

While the SRAM bit cell 10A of Figure 1A is used in many applications, one common variation on the SRAM bit cell 10A is a bit cell with multiple R/W ports. In this regard, Figure 1B illustrates SRAM bit cell 10B with multiple R/W ports. A first bit line bar 24A couples to the source of a first first PG transistor 18A while a second bit line bar 24B couples to the source of a second first PG transistor 18B. The drains of the first PG transistors 18A, 18B share a common node coupled to the first inverter 12. Similarly, a first bit line 22A couples to the source of a first second PG transistor 20A and a second bit line 22B couples to the source of a second second PG transistor 20B. The drains of the second PG transistors 20A, 20B share a common node coupled to the second inverter 14. Multiple write lines 16A, 16B may be coupled to the PG transistors 18A, 18B, 20A, 20B. Additionally, first read transistors 38 may be coupled to the first inverter 12, and second read transistors 40 may be coupled to the second inverter 14. While only two bit lines and two bit line bar inputs are shown, it should be appreciated that more may be present with the appropriate PG transistor.

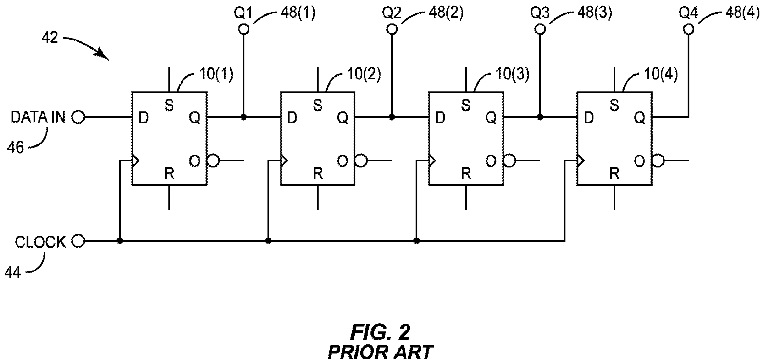

SRAM bit cells are, in essence, the fundamental building blocks of a register file and, as such, SRAM bit cells 10A, 10B may be assembled into a register such as a shift register 42 as illustrated in Figure 2. Shift register 42 is a four bit shift register including four SRAM bit cells 10(1)-10(4). A clock signal 44 may be provided to each bit cell if desired. Data is initially provided on the data in line 46. Outputs 48(1)-48(4) are provided for respective bit cells 10(1)-10(4). While a four bit shift register 42 is illustrated, it should be appreciated that more bit cells may be assembled into larger registers. While a shift register is specifically illustrated, registers of various configurations are possible and all fall within the term "register file" as that term is used herein.

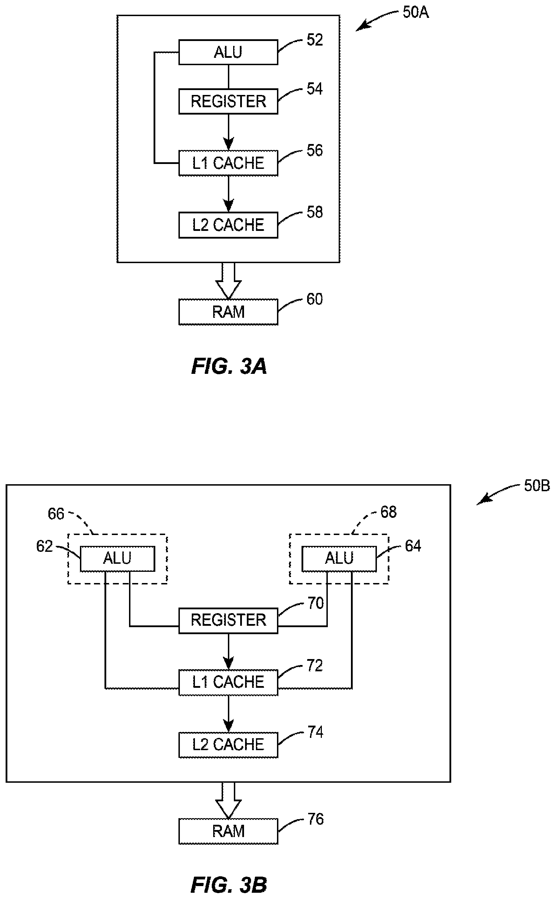

Registers serve a useful function in computing devices providing a memory block that is fast to access, and registers eliminate the need to access slower memory such as a hard drive. The registers may be associated with an arithmetic logic unit (ALU). Furthermore, unlike a cache memory which may effectively only be read by the processing core, registers may be both read and write allowing the ALU to store data being manipulated. Because of their heavy use, registers are frequently positioned within the same integrated circuit as the ALU as further illustrated in Figures 3A and 3B.

In this regard, Figure 3A illustrates an exemplary IC 50A having a processing core that uses an ALU 52. The ALU 52 is associated with and communicates with a register 54 as well as a level one (LI) cache 56 and a level two (L2) cache 58. In an exemplary embodiment, the ALU 52 communicates with the L1 cache 56 through the register 54. In an alternate embodiment, the ALU 52 may communicate with the L1 cache 56 directly without passing through the register 54. The IC 50A may communicate with external memory devices such as a RAM 60. In the exemplary embodiment, the IC 50A has a single core and a single ALU 52, thus, the register 54 only serves the single ALU 52. However, some ICs may have a single core and multiple ALU (not shown). In such an embodiment, the registers may be coupled to the various ALU as is well understood. Furthermore, the computing industry increasingly relies on multi-core processors each with one or more ALU.

In this regard, Figure 3B illustrates an exemplary IC 50B comprising a multi-core processor that uses a first ALU 62 within a first core 66 and a second ALU 64 within a second core 68. As noted above, the cores 66, 68 may have multiple ALU (not shown). The ALUs 62, 64 may cooperatively use a shared register 70, which may have one or more multi-port SRAM bitcells 10B to facilitate the shared usage. It should be appreciated that the ALUs 62, 64 may also have dedicated registers (not shown) which function for timing critical circuits associated with the particular ALU 62, 64. The ALUs 62, 64 may further use the L1 cache 72 and the L2 cache 74 as is well understood. As noted above, in an exemplary embodiment, the ALUs 62, 64, may communicate with the L1 cache 72 through the register 70. The IC 50B may further communicate with an external memory, such as RAM 76. While the discussion of Figures 1A-3B focuses on the use of SRAM bitcells in a register, it should be appreciated that other memory blocks such as the L1 or L2 cache or external RAM may also be formed from SRAM bitcells.

Against this general use of SRAM bit cells, it should be appreciated that current efforts to miniaturize ICs necessitate ever increasing demands on space use within an IC, such as ICs 50A, 50B. Additionally, as memory demands increase in multi-thread processors, the size of SRAM based register files increases. The larger the register, the more latency occurs during register file access. Further, as the number of bit cells increases, the peripheral logic area increases and may produce retiming arcs for other components placed around the register file. In addition to miniaturization concerns, there is increasing concern about power consumption, which reduces V_{DD} for the bit cells. If V_{DD} becomes too small, the SNM and RWNM become limiting factors and can be optimized by separating the power supplies of read and write operations. Routing the conductive paths for each voltage source then becomes a further bottleneck for a low power system and having multiple power supply rails inside the register file leads to a further area penalty. As is readily understood, these problems synergistically feed one another causing difficulties for circuit designers.

The present disclosure remedies the deficiencies of the current state of the art by providing a register file core cell design with different elements of the register file spread across multiple tiers of a 3DIC. By splitting the register file across the tiers of the 3DIC the routing for the various power rails and access lines is simplified and the overall footprint of the register is reduced. Reduction of the footprint reduces latency and reduces the likelihood of retiming arcs.

In this regard, Figure 4 illustrates a 3DIC 80 having a first tier 82 and a second tier 84 with a register file 86 spread across the first tier 82 and the second tier 84. In the illustrated embodiment of Figure 4, the read access related stages 88 (including a processor core read logic and a read access port configured to provide read access) and the read transistors 90 are positioned in the first tier 82 while the write access related stages 92 (including a processor core write logic and a write access port configured to provide write access) and the inverters of the SRAM cell 94 are positioned in the second tier 84, thereby positioning the memory cell portion of the register file 86 in the second tier 84. The read transistors 90 communicate with the inverters of the SRAM cell 94. In an exemplary embodiment, the read transistors 90 are coupled to the SRAM cell 94 with one or more monolithic intertier vias (MIV) 96. By splitting the register file 86 across multiple tiers 82, 84 of the 3DIC 80, the overall footprint of the register file 86 is reduced compared to a two dimensional register file. Furthermore, by separating the read transistors 90 from the SRAM cell 94, routing issues relating to routing voltage rails and the multiple access ports are eased. Thus, as illustrated a first power island 95A is provided on the first tier 82 and provides V_{DD_READ} to the appropriate elements within the read transistors 90 and the read access related stages 88. Likewise, a second power island 95B is provided on the second tier 84 and provides V_{DD_WRITE} to the appropriate elements within the SRAM cell 94 and write access related stages 92. The inclusion of separate voltage rails helps mitigate the SNM such that inadvertent flips of the memory bit are avoided. Note that the typical SRAM cell 94 is approximately 0.1 to 0.09 square microns. A typical through silicon via (TSV) has a diameter of about 5 microns - i.e., much larger than the SRAM cell 94. MIV 96 are much smaller than a TSV, being approximately 0.05 microns and thus the use of MIV 96 instead of TSV preserves the footprint savings of splitting the register file 86 across the multiple tiers 82, 84. As used herein a means for reading is used to designate the read access port and equivalents. Likewise, as used herein, a means for writing is used to designate the write access port and equivalents.

The concept of the MIV was published in a paper entitled "High-Density Integration of Functional Modules Using Monolithic 3D-IC Technology" by Shreedpad Panth et al. in the proceedings of the IEEE/ACM Asia South Pacific Design Automation Conference, 2013; pp. 681-686.

While Figure 4 illustrates the write access related stages 92 on the second tier 84, in another exemplary embodiment, the write access related stages 92 may be on the first tier 82. If the write access related stages 92 are on the first tier 82, then MIVs 96 may be used to couple the write access related stages 92 to the SRAM cell 94.

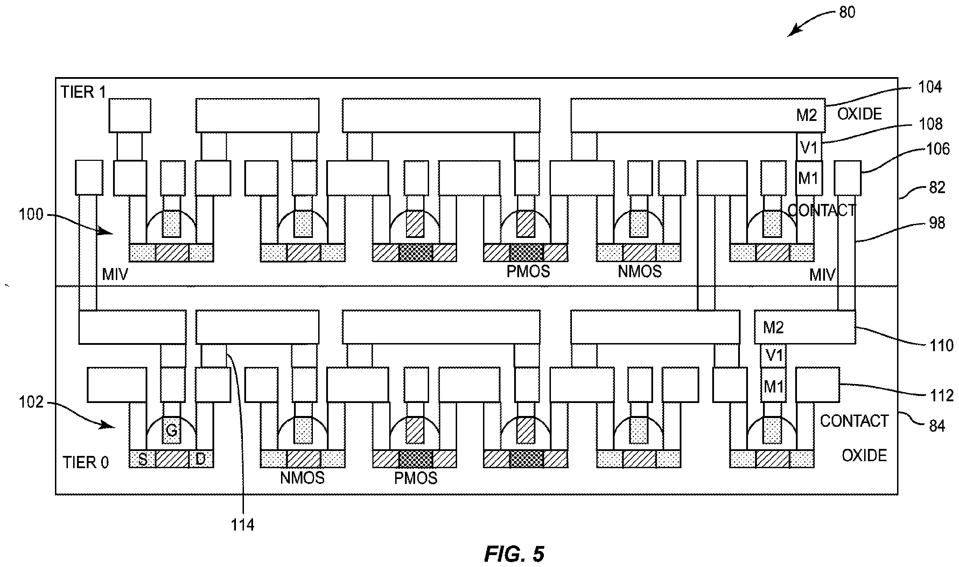

Figure 5 illustrates a cross-sectional view of the 3DIC 80 with first tier 82 and second tier 84 coupled with MIV 98. Elements 100 are positioned within the first tier 82 including one or more transistors, which may be PMOS or NMOS transistors. Elements 102 are positioned within the second tier 84 including one or more transistors, which may likewise be PMOS or NMOS transistors. The elements 100 may include one or more metal layers 104, 106 coupled by vias 108. The elements 102 may include one or more metal layers 110, 112 coupled by vias 114. The metal layers 104, 106, 110, 112 provide horizontal interconnections and facilitating conductive routing paths within the 3DIC. The small MIV size, which is about the same size of conventional interconnect via, creates a very high density of inter-tier connections, making separation of read and write ports to different tiers possible and economically viable.

The multi-tier register file 86 is particularly well suited for multi-core processors. That is, the multi-tier register file 86 may be shared between cores of a multi-core processor such as multi-core IC 50B shown schematically in Fig 3B, and allows the cores to be positioned on different tiers within the 3DIC 80. Such flexibility in positioning assists designers in routing conductive paths, reducing latency and otherwise improving performance of the multi-core processors.

The register files in the 3DICs according to embodiments disclosed herein may be provided in or integrated into any processor-based device. Examples, without limitation, include a set top box, an entertainment unit, a navigation device, a communications device, a fixed location data unit, a mobile location data unit, a mobile phone, a cellular phone, a computer, a portable computer, a desktop computer, a personal digital assistant (PDA), a monitor, a computer monitor, a television, a tuner, a radio, a satellite radio, a music player, a digital music player, a portable music player, a digital video player, a video player, a digital video disc (DVD) player, and a portable digital video player.

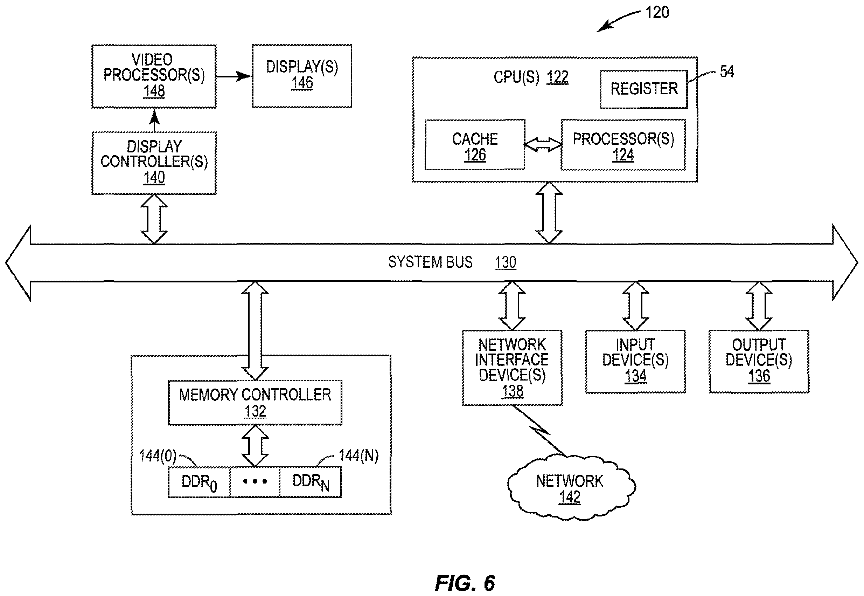

In this regard, Figure 6 illustrates an example of a processor-based system 120 that can employ the register files in the 3DIC illustrated in Figures 4 and 5. In this example, the processor-based system 120 includes one or more central processing units (CPUs) 122, each including one or more processors 124. The CPU(s) 122 may include a register 54 and/or may be a master device. The CPU(s) 122 may have cache memory 126 coupled to the processor(s) 124 for rapid access to temporarily stored data. The CPU(s) 122 is coupled to a system bus 130 and can intercouple master devices and slave devices included in the processor-based system 120. As is well known, the CPU(s) 122 communicates with these other devices by exchanging address, control, and data information over the system bus 130. For example, the CPU(s) 122 can communicate bus transaction requests to the memory controller 132 as an example of a slave device. Although not illustrated in Figure 6, multiple system buses 130 could be provided, wherein each system bus 130 constitutes a different fabric.

Other master and slave devices can be connected to the system bus 130. As illustrated in Figure 6, these devices can include a memory controller 132, one or more input devices 134, one or more output devices 136, one or more network interface devices 138, and one or more display controllers 140, as examples. The input device(s) 134 can include any type of input device, including but not limited to input keys, switches, voice processors, etc. The output device(s) 136 can include any type of output device, including but not limited to audio, video, other visual indicators, etc. The network interface device(s) 138 can be any devices configured to allow exchange of data to and from a network 142. The network 142 can be any type of network, including but not limited to a wired or wireless network, private or public network, a local area network (LAN), a wide local area network (WLAN), and the Internet. The network interface device(s) 138 can be configured to support any type of communication protocol desired. The memory controller 132 can include one or more memory units 144 (0-N).

The CPU(s) 122 may also be configured to access the display controller(s) 140 over the system bus 130 to control information sent to one or more displays 146. The display controller(s) 140 sends information to the display(s) 146 to be displayed via one or more video processors 148, which process the information to be displayed into a format suitable for the display(s) 146. The display(s) 146 can include any type of display, including but not limited to a cathode ray tube (CRT), a liquid crystal display (LCD), a plasma display, etc.

Those of skill in the art will further appreciate that the various illustrative logical blocks, modules, circuits, and algorithms described in connection with the embodiments disclosed herein may be implemented as electronic hardware, instructions stored in memory or in another computer-readable medium and executed by a processor or other processing device, or combinations of both. The arbiters, master devices, and slave devices described herein may be employed in any circuit, hardware component, IC, or IC chip, as examples. Memory disclosed herein may be any type and size of memory and may be configured to store any type of information desired. To clearly illustrate this interchangeability, various illustrative components, blocks, modules, circuits, and steps have been described above generally in terms of their functionality. How such functionality is implemented depends upon the particular application, design choices, and/or design constraints imposed on the overall system. Skilled artisans may implement the described functionality in varying ways for each particular application, but such implementation decisions should not be interpreted as causing a departure from the scope of the present disclosure.

The various illustrative logical blocks, modules, and circuits described in connection with the embodiments disclosed herein may be implemented or performed with a processor, a Digital Signal Processor (DSP), an Application Specific Integrated Circuit (ASIC), a Field Programmable Gate Array (FPGA) or other programmable logic device, discrete gate or transistor logic, discrete hardware components, or any combination thereof designed to perform the functions described herein. A processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The embodiments disclosed herein may be embodied in hardware and in instructions that are stored in hardware, and may reside, for example, in Random Access Memory (RAM), flash memory, Read Only Memory (ROM), Electrically Programmable ROM (EPROM), Electrically Erasable Programmable ROM (EEPROM), registers, a hard disk, a removable disk, a CD-ROM, or any other form of computer readable medium known in the art. An exemplary storage medium is coupled to the processor such that the processor can read information from, and write information to, the storage medium. In the alternative, the storage medium may be integral to the processor. The processor and the storage medium may reside in an ASIC. The ASIC may reside in a remote station. In the alternative, the processor and the storage medium may reside as discrete components in a remote station, base station, or server.

It is also noted that the operational steps described in any of the exemplary embodiments herein are described to provide examples and discussion. The operations described may be performed in numerous different sequences other than the illustrated sequences. Furthermore, operations described in a single operational step may actually be performed in a number of different steps. Additionally, one or more operational steps discussed in the exemplary embodiments may be combined. It is to be understood that the operational steps illustrated in the flow chart diagrams may be subject to numerous different modifications as will be readily apparent to one of skill in the art. Those of skill in the art will also understand that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

The previous description of the disclosure is provided to enable any person skilled in the art to make or use the disclosure. Various modifications to the disclosure will be readily apparent to those skilled in the art, and the generic principles defined herein may be applied to other variations without departing from the scope of the disclosure. Thus, the disclosure is not intended to limit the scope of invention which is defined in the appended claims.

## Claims

1. A monolithic three-dimensional, 3D, memory block (80), comprising:
a static random access memory, SRAM, memory cell (94), the memory cell disposed in a first tier (84) of a 3D integrated circuit, IC, referred to as 3DIC;
at least one read access port (90) disposed in a second tier (82) of the 3DIC configured to provide read access to the memory cell (94), wherein each read access port comprises a first read transistor coupled to a first inverter of the SRAM and a second read transistor coupled to a second inverter of the SRAM;
at least one monolithic intertier via, MIV, (96) coupling the at least one read access port (90) to the memory cell (94);and at least one write access port disposed in the first tier of 1 the 3DIC configured to provide write access to the memory cell (94).

2. The 3D memory block (80) of claim 1, further comprising:
a processor core write logic (92) disposed in the first tier (84) of the 3DIC, the processor core write logic configured to provide write requests to the at least one write port of the memory cell; and
a processor core read logic (88) disposed in the second tier (82) of the 3DIC, the processor core read logic configured to provide read accesses to the at least one read access port of the memory cell.

3. The 3D memory block (80) of claim 1, further comprising:
a first voltage rail (95B) supplied with a first voltage disposed in the first tier of the 3DIC, the first voltage rail configured to supply the first voltage to the memory cell; and
a second voltage rail (95A) supplied with a second voltage lower than the first voltage supplied to the first voltage rail, the second voltage rail disposed in the second tier of the 3DIC and configured to supply the second voltage to the at least one read access port.

4. The 3D memory block (80) of claim 1 integrated into a semiconductor die.

5. The 3D memory block of claim 1, wherein the 3D memory block comprises a register (86) within an integrated circuit and/or cache memory within an integrated circuit.

6. A method of forming a monolithic three dimensional, 3D, memory block (80), comprising:
forming a first tier (84) of a 3D integrated circuit, IC, referred to as 3DIC;
forming a static random access memory, SRAM, memory cell (94) within the first tier (84) of the 3DIC;
forming a second tier (82) of the 3DIC;
forming at least one read access port within the second tier of the 3DIC, the at least one read access port is configured to provide read access to the memory cell (94), wherein forming the at least one read access port comprises:
forming a first read transistor (90) coupled to a first inverter of the SRAM block; and
forming a second read transistor (90) coupled to a second inverter of the SRAM block;
coupling the at least one read access port to the memory cell (94) with at least one monolithic intertier via, MIV (96), and
forming at least one write access port on the first tier of the 3DIC, the at least one write access port configured to provide write access to the memory cell.

7. The method of claim 6, further comprising configuring the memory cell (94) to operate as a register (86).

8. The method of claim 6, further comprising:
forming a processor core write logic (92) within the first tier (84) of the 3DIC, the processor core write logic configured to provide write requests to at least one write port of the memory cell (94); and
forming a processor core read logic (88) within the second tier (81) of the 3DIC, the processor core read logic configured to provide read accesses to the at least one read access port of the memory cell.

9. The method of claim 6, further comprising:
forming a first voltage rail (95B) within the first tier of the 3DIC, the first voltage rail configured to supply a first voltage to the memory cell; and
forming a second voltage rail (95A) within the second tier of the 3DIC and configured to supply a second voltage to the at least one read access port.

## Patentansprüche

1. Ein monolithischer dreidimensionaler Speicherblock bzw. 3D-Speicherblock (80), der Folgendes aufweist:
eine SRAM-Speicherzelle (SRAM = static random access memory bzw. statischer Speicher mit wahlfreiem Zugriff) (94), wobei die Speicherzelle in einem ersten Rang bzw. einer ersten Ebene (84) eines dreidimensionalen integrierten Schaltkreises, der als 3DIC (IC = integrated circuit) bezeichnet wird, angeordnet ist;
wenigstens einen Lesezugriffsport (90), der in einer zweiten Ebene (82) des 3DIC angeordnet ist, der konfiguriert ist zum Vorsehen von Lesezugriff auf die Speicherzelle (94), wobei jeder Lesezugriffsport einen ersten Lesetransistor aufweist, der an einen ersten Inverter des SRAM gekoppelt ist, und einen zweiten Lesetransistor, der an einen zweiten Inverter des SRAM gekoppelt ist;
wenigstens ein monolithisches Zwischenebenen-Via bzw. MIV (MIV = monolithic intertier via) (96), das den wenigstens einen Lesezugriffsport (90) an die Speicherzelle (94) gekoppelt; und
wenigstens einen Lesezugriffsport, der in der ersten Ebene des 3DIC angeordnet ist, der konfiguriert ist zum Vorsehen von Schreibzugriff auf die Speicherzelle (94).

2. 3D-Speicherblock (80) nach Anspruch 1, der weiter Folgendes aufweist:
eine Prozessorkernschreiblogik (92), die in der ersten Ebene (84) des 3DIC angeordnet ist,
wobei die Prozessorkernlogik konfiguriert ist zum Vorsehen von Schreibanfragen an den wenigstens einen Schreibport der Speicherzelle; und
eine Prozessorkernleselogik (88), die in der zweiten Ebene (82) des 3DIC angeordnet ist, wobei die Prozessorkernleselogik konfiguriert ist zum Vorsehen von Lesezugriffen auf den wenigstens einen Lesezugriffsport der Speicherzelle.

3. 3D-Speicherblock (80) nach Anspruch 1, der weiter Folgendes aufweist:
eine erste Spannungsschiene (95B), die mit einer ersten Spannung versorgt wird, die in der ersten Ebene des 3DIC angeordnet ist, wobei die erste Spannungsschiene konfiguriert ist die erste Spannung an die Speicherzelle zu liefern; und
eine zweite Spannungsschiene (95A), die mit einer zweiten Spannung versorgt wird, die niedriger ist als die erste Spannung, die an die erste Spannungsschiene geliefert wird, wobei die zweite Spannungsschiene in der zweiten Ebene des 3DIC angeordnet ist und konfiguriert ist die zweite Spannung an den wenigstens einen Lesezugriffsport zu liefern.

4. 3D-Speicherblock (80) nach Anspruch 1, der in einen Halbleiter-Die integriert ist.

5. 3D-Speicherblock nach Anspruch 1, wobei der 3D-Speicherblock ein Register (86) innerhalb eines integrierten Schaltkreises und/oder Cache-Speicher innerhalb eines integrierten Schaltkreises aufweist.

6. Ein Verfahren zum Bilden eines monolithischen dreidimensionalen Speicherblockes bzw. 3D-Speicherblockes (80), das Folgendes aufweist:
Bilden einer ersten Ebene (84) eines dreidimensionalen integrierten Schaltkreises, der als 3DIC bezeichnet wird (IC = integrated circuit);
Bilden einer SRAM-Speicherzelle (SRAM = static random access memory bzw. statischer Speicher mit wahlfreiem Zugriff) (94) innerhalb der ersten Ebene (84) des 3DIC;
Bilden einer zweiten Ebene (82) des 3DIC;
Bilden von wenigstens einem Lesezugriffsport innerhalb der zweiten Ebene des 3DIC, wobei der wenigstens eine Lesezugriffsport konfiguriert ist zum Vorsehen von Lesezugriff auf die Speicherzelle (94), wobei das Bilden des wenigstens einen Lesezugriffsports Folgendes aufweist:
Bilden eines ersten Lesetransistors (90), der an einen ersten Inverter des SRAM-Blockes gekoppelt ist; und
Bilden eines zweiten Lesetransistors (90), der an einen zweiten Inverter des SRAM-Blockes gekoppelt ist;
Koppeln des wenigstens einen Lesezugriffsports an die Speicherzelle (94) mit wenigstens einem monolithischen Zwischenebenen-Via bzw. MIV (MIV = monolithic intertier via) (96), und
Bilden wenigstens eines Schreibzugriffsports auf der ersten Ebene des 3DIC, wobei der wenigstens eine Schreibzugriffsport konfiguriert ist Schreibzugriff auf die Speicherzelle vorzusehen.

7. Verfahren nach Anspruch 6, das weiter Konfigurieren der Speicherzelle (94) aufweist, als ein Register (86) zu arbeiten.

8. Verfahren nach Anspruch 6, das weiter Folgendes aufweist:
Bilden einer Prozessorkernschreiblogik (92) innerhalb der ersten Ebene (84) des 3DIC, wobei die Prozessorkernschreiblogik konfiguriert ist zum Vorsehen von Schreibanfragen an wenigstens einen Schreibort der Speicherzelle (94); und
Bilden einer Prozessorkernleselogik (88) innerhalb der zweiten Ebene (81) des 3DIC, wobei die Prozessorkernleselogik konfiguriert ist zum Vorsehen von Lesezugriffen an den wenigstens einen Lesezugriffsport der Speicherzelle.

9. Verfahren nach Anspruch 6, das weiter Folgendes aufweist:
Bilden einer ersten Spannungsschiene (95B) innerhalb der ersten Ebene des 3DIC, wobei die Spannungsschiene konfiguriert ist zum Liefern einer ersten Spannung an die Speicherzelle; und
Bilden einer zweiten Spannungsschiene (95A) innerhalb der zweiten Ebene des 3DIC und die konfiguriert ist zum Liefern einer zweiten Spannung an den wenigstens einen Lesezugriffsport.

## Revendications

1. Bloc mémoire tridimensionnel, 3D, monolithique (80) comprenant :
une cellule mémoire vive statique, SRAM, (94), la cellule mémoire étant disposée dans un premier étage (84) d'un circuit intégré, IC, 3D, désigné par 3DIC ;
au moins un port d'accès de lecture (90) disposé dans un deuxième étage (82) du 3DIC configuré pour fournir un accès de lecture à la cellule mémoire (94), dans lequel chaque port d'accès de lecture comprend un premier transistor de lecture couplé à un premier inverseur de la SRAM et un deuxième transistor de lecture couplé à un deuxième inverseur de la SRAM ;
au moins un via inter-étage monolithique, MIV, (96) couplant ledit au moins un port d'accès de lecture (90) à la cellule mémoire (94) ; et
au moins un port d'accès d'écriture disposé dans le premier étage du 3DIC configuré pour fournir un accès d'écriture à la cellule mémoire (94).

2. Bloc mémoire 3D (80) selon la revendication 1, comprenant en outre :
une logique d'écriture de cœur de processeur (92) disposée dans le premier étage (84) du 3DIC, la logique d'écriture de cœur de processeur étant configurée pour fournir des requêtes d'écriture audit au moins un port d'écriture de la cellule mémoire ; et
une logique de lecture de cœur de processeur (88) disposée dans le deuxième étage (82) du 3DIC, la logique de lecture de cœur de processeur étant configurée pour fournir des accès de lecture audit au moins un port d'accès de lecture de la cellule mémoire.

3. Bloc mémoire 3D (80) selon la revendication 1, comprenant en outre :
un premier rail de tension (95B) alimenté par une première tension disposé dans le premier étage du 3DIC, le premier rail de tension étant configuré pour fournir la première tension à la cellule mémoire ; et
un deuxième rail de tension (95A) alimenté par une deuxième tension inférieure à la première tension fournie au premier rail de tension, le deuxième rail de tension étant disposé dans le deuxième étage du 3DIC et configuré pour fournir la deuxième tension audit au moins un port d'accès de lecture.

4. Bloc mémoire 3D (80) selon la revendication 1 intégré dans une puce semiconductrice.

5. Bloc mémoire 3D (80) selon la revendication 1, dans lequel le bloc mémoire 3D comprend un registre (86) dans un circuit intégré et/ou une mémoire cache dans un circuit intégré.

6. Procédé de formation d'un bloc mémoire tridimensionnel, 3D, (80), comprenant :
la formation d'un premier étage (84) d'un circuit intégré, IC, 3D, désigné par 3DIC ;
la formation d'une cellule mémoire vive statique, SRAM, (94) dans le premier étage (84) du 3DIC ;
la formation d'un deuxième étage (82) du 3DIC ;
la formation d'au moins un port d'accès de lecture dans le deuxième étage du 3DIC, ledit au moins un port d'accès de lecture est configuré pour fournir un accès de lecture à la cellule mémoire (84), dans lequel la formation dudit au moins un port d'accès de lecture comprend :
la formation d'un premier transistor de lecture (90) couplé à un premier inverseur du bloc SRAM ; et
la formation d'un deuxième transistor de lecture (90) couplé à un deuxième inverseur du bloc SRAM ;
le couplage dudit au moins un port d'accès de lecture à la cellule mémoire (94) avec au moins un via inter-étage monolithique, MIV (96), et
la formation d'au moins un port d'accès d'écriture sur le premier étage du 3DIC, ledit au moins un port d'accès d'écriture étant configuré pour fournir un accès d'écriture à la cellule mémoire.

7. Procédé selon la revendication 6, comprenant en outre la configuration de la cellule mémoire (94) pour qu'elle fonctionne comme un registre (86) .

8. Procédé selon la revendication 6, comprenant en outre :
la formation d'une logique d'écriture de cœur de processeur (92) dans le premier étage (84) du 3DIC, la logique d'écriture de cœur de processeur étant configurée pour fournir des requêtes d'écriture audit au moins un port d'écriture de la cellule mémoire (94) ; et
la formation d'une logique de lecture de cœur de processeur (88) dans le deuxième étage (82) du 3DIC, la logique de lecture de cœur de processeur étant configurée pour fournir des accès de lecture audit au moins un port d'accès de lecture de la cellule mémoire.

9. Procédé selon la revendication 6, comprenant en outre :
la formation d'un premier rail de tension (95B) dans le premier étage du 3DIC, le premier rail de tension étant configuré pour fournir une première tension à la cellule mémoire ; et
la formation d'un deuxième rail de tension (95A) dans le deuxième étage du 3DIC et configuré pour fournir une deuxième tension audit au moins un port d'accès de lecture.
